# EUROPEAN PATENT APPLICATION

(11) **EP 4 773 763 A1**
(43) Date of publication of application: **08.07.2026**
(21) Application number: 23958395.8
(22) Date of filing: 09.11.2023
(51) Int. Cl.: H10H 20/831, H10H 20/841, H10H 20/857, H01L 25/075, H01L 23/00

(54) **SEMICONDUCTOR LIGHT-EMITTING ELEMENT FOR DISPLAY PIXEL, AND DISPLAY DEVICE COMPRISING SAME**

(71) Applicant: LG Electronics Inc., Yeongdeungpo-gu Seoul 07336 (KR)
(72) Inventor: KIM, Chanseok, Seoul 06772 (KR); YANG, Youngsung, Seoul 06772 (KR); KANG, Byungjun, Seoul 06772 (KR)
(74) Representative: Schornack, Oliver
(86) International application number: PCT/KR2023/017939
(87) International publication number: WO 2025/100596

(57) **Abstract**

A semiconductor light-emitting device for a display pixel according to an embodiment includes a light-emitting structure comprising a first conductivity-type semiconductor layer, an active layer, and a second conductivity-type semiconductor layer; and a first electrode disposed below the light-emitting structure, wherein a lower surface of the first electrode comprises an electrode region and a first region, and the semiconductor light-emitting device may further include an aligner disposed in the first region, and the aligner may include an insulating material.

## Description

### Technical Field

An embodiment relates to a semiconductor light-emitting device for a display pixel and a display device including the same.

### Background Art

Large-area displays include a liquid crystal display (LCD), an OLED display, and a micro-LED display (Micro-LED display).

A micro-LED display is a display using, as a display device, a micro-LED which is a semiconductor light-emitting device having a diameter or cross-sectional area of 100 µm or less.

Since the micro-LED display uses the micro-LED which is the semiconductor light-emitting device as the display device, the micro-LED display has excellent performance in many characteristics such as contrast ratio, response speed, color reproduction rate, viewing angle, brightness, resolution, lifetime, luminous efficiency, and luminance.

In particular, the micro-LED display has advantages in that a screen may be separated and combined in a module manner so that size or resolution may be freely adjusted and that a flexible display may be implemented.

However, since a large micro-LED display requires several million or more micro-LEDs, there is a technical problem in that it is difficult to transfer the micro-LEDs to a display panel rapidly and accurately.

Recently developed transfer technologies include a pick and place process, a laser lift-off method, or a self-assembly method.

Among these, the self-assembly method is a method in which the semiconductor light-emitting device finds an assembly position by itself in a fluid and is advantageous for implementation of a display device having a large screen.

Recently, U.S. Patent No. 9,825,202 has presented a micro-LED structure suitable for self-assembly, but research on a technology for manufacturing a display through self-assembly of the micro-LED is still insufficient.

In particular, in the related art, when several million or more semiconductor light-emitting devices are rapidly transferred to a large display, transfer speed may be improved, but a transfer error rate may increase so that there is a technical problem in that a transfer yield decreases.

Meanwhile, in the related art, a transfer process using the self-assembly method using dielectrophoresis (DEP) has been attempted, but there is a problem in that a self-assembly rate is low due to non-uniformity of a DEP force.

In addition, when the semiconductor light-emitting device is transferred to a substrate, the semiconductor light-emitting device may be disposed to be biased to one side. Accordingly, a double defect in which another chip is caught may occur, or a problem in which the chip cannot be picked up at a correct position in a subsequent pick and place process occurs.

### Detailed Description of the Invention

### Technical Problem

One of technical problems of an embodiment is to prevent a double defect during self-assembly.

In addition, one of technical problems of an embodiment is to prevent a previously assembled chip from being separated during self-assembly.

In addition, one of technical problems of an embodiment is to improve a transfer rate during self-assembly.

In addition, one of technical problems of an embodiment is to improve an assembly force during self-assembly.

In addition, one of technical problems of an embodiment is to physically fix a chip to a substrate without a separate member.

The technical problems of the embodiment are not limited to those described in this section and include those that may be understood through the description of the invention.

### Technical Solution

A semiconductor light-emitting device for a display pixel according to an embodiment may include a light-emitting structure including a first conductivity-type semiconductor layer, an active layer, and a second conductivity-type semiconductor layer; and a first electrode disposed below the light-emitting structure.

A lower surface of the first electrode may include an electrode region and a first region.

The embodiment may further include an aligner of an insulating material disposed in the first region of the first electrode.

In addition, in the embodiment, a center of the aligner may correspond to a center of the first electrode.

In addition, in the embodiment, the electrode region may be defined by the aligner.

For example, the electrode region may not overlap the aligner in a vertical direction.

In addition, in the embodiment, the aligner may cross a center of the lower surface of the first electrode.

In addition, in the embodiment, the aligner may include a ring shape in a horizontal cross section.

In addition, the embodiment may further include a magnetic layer disposed in the aligner.

In addition, in the embodiment, the first region (141) may surround the electrode region.

In addition, a display device including a semiconductor light-emitting device according to another embodiment includes a substrate; a plurality of assembly wirings disposed on the substrate; and an insulating layer disposed on the assembly wirings;
a partition wall disposed on the insulating layer and including an assembly hole; and a semiconductor light-emitting device disposed in the assembly hole, wherein the semiconductor light-emitting device includes a light-emitting structure, a first electrode disposed below the light-emitting structure, and an aligner disposed below the first electrode, the aligner includes an insulating material, and the insulating layer may have a first groove corresponding to a shape of the aligner.

In addition, in the embodiment, the aligner may be positioned between the plurality of assembly wirings.

In addition, in the embodiment, the plurality of assembly wirings may have a second groove corresponding to the shape of the aligner.

The semiconductor light-emitting device may include the semiconductor light-emitting device for a display pixel according to any one of the above.

### Advantageous Effects

The semiconductor light-emitting device for a display pixel and the display device including the same according to the embodiment have a technical effect of preventing a double defect in which two or more chips are assembled in one assembly hole during self-assembly.

For example, in the embodiment, as the semiconductor light-emitting device is positioned at a center of the assembly hole by the aligner, a remaining space is reduced so that an additional chip is prevented from being additionally assembled.

In addition, the embodiment has a technical effect of improving a transfer rate during self-assembly.

For example, in the embodiment, the semiconductor light-emitting device is positioned at a center of the assembly hole so that the semiconductor light-emitting device is transferred to a correct position during the transfer process and thus the transfer rate can be improved.

In addition, the embodiment has a technical effect of preventing separation of the assembled chip.

For example, in the embodiment, the semiconductor light-emitting device is fixed to the substrate by the aligner so that separation of the chip can be prevented.

In addition, the embodiment has a technical effect of improving an assembly force during self-assembly.

For example, in the embodiment, a region receiving a DEP force is symmetrically disposed based on the rear aligner so that the assembly force can be improved.

In addition, the embodiment has a technical effect of physically fixing the chip to the substrate without a separate member.

For example, in the embodiment, the rear aligner performs an anchor function so that the chip can be physically fixed to the substrate without a separate member.

The technical effects of the embodiment are not limited to those described in this section and include those that may be understood through the description of the invention.

### Description of Drawings

FIG. 1 is an example view of a living room of a house in which a display device according to an embodiment is disposed.
FIG. 2 is an enlarged view of a first panel region in the display device of FIG. 1.
FIG. 3 is a cross-sectional view taken along line B1-B2 of region A2 of FIG. 2.
FIG. 4 is an example view in which a light-emitting device according to an embodiment is assembled on a substrate by a self-assembly method.
FIG. 5 is a conceptual view of an assembly substrate of a semiconductor light-emitting device studied in internally developed technology.
FIG. 6 is a cross-sectional view of a semiconductor light-emitting device for a display pixel according to a first embodiment.
FIGS. 7A to 7D are conceptual views illustrating a rear surface of the semiconductor light-emitting device for a display pixel according to second to fifth embodiments.
FIG. 8 is a process diagram illustrating an assembly process in a display device including a semiconductor light-emitting device according to a sixth embodiment.
FIG. 9 is a conceptual view of a display device including a semiconductor light-emitting device according to the sixth embodiment.
FIG. 10 is a conceptual view of a display device including a semiconductor light-emitting device according to a seventh embodiment.

### Mode for Invention

Hereinafter, embodiments disclosed in the present specification will be described in detail with reference to the accompanying drawings. The suffixes "module" and "unit" for components used in the following description are assigned or used interchangeably in consideration of convenience in writing the specification, and do not have meanings or roles distinguished from each other by themselves. In addition, the accompanying drawings are provided to facilitate understanding of the embodiments disclosed in the present specification, and the technical spirit disclosed in the present specification is not limited by the accompanying drawings. Further, when an element such as a layer, region, or substrate is referred to as being on another element, this includes not only being directly on the other element but also a case where another intermediate element may exist therebetween.

The display device described in the present specification may include a digital TV, a mobile phone, a smart phone, a laptop computer, a terminal for digital broadcasting, a PDA (personal digital assistant), a PMP (portable multimedia player), a navigation device, a slate PC, a tablet PC, an ultra-book, a desktop computer, and the like. However, the configuration according to the embodiment described in the present specification may also be applied to a device capable of displaying even if it is a new product type developed in the future.

Hereinafter, a light-emitting device according to the embodiment and a display device including the same will be described.

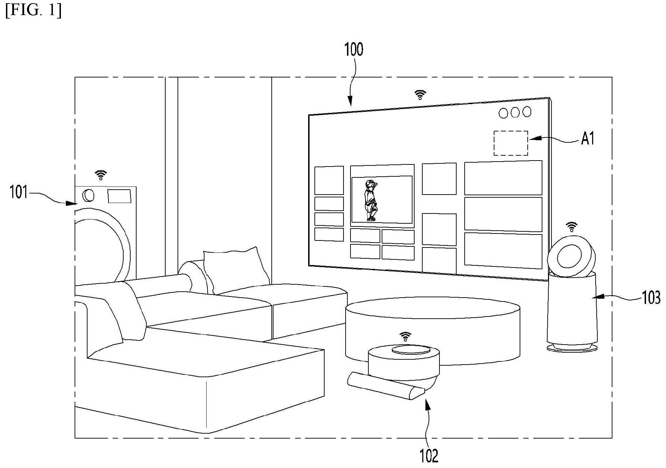

FIG. 1 illustrates a living room of a house in which a display device (100) according to the embodiment is disposed.

The display device (100) of the embodiment may display states of various electronic products such as a washing machine (101), a robot cleaner (102), and an air purifier (103), may communicate with each electronic product based on IOT, and may also control each electronic product based on user setting data.

The display device (100) according to the embodiment may include a flexible display manufactured on a thin and flexible substrate. The flexible display may be bent or rolled like paper while maintaining characteristics of a conventional flat display.

In the flexible display, visual information may be implemented by independently controlling light emission of unit pixels arranged in a matrix form. The unit pixel means a minimum unit for implementing one color. The unit pixel of the flexible display may be implemented by a light-emitting device. In the embodiment, the light-emitting device may be a Micro-LED or a Nano-LED, but is not limited thereto.

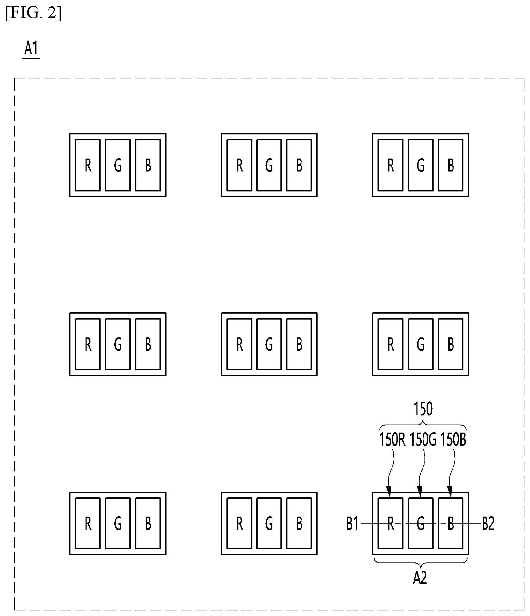

FIG. 2 is an enlarged view of a first panel region (A1) in the display device of FIG. 1.

According to FIG. 2, the display device (100) of the embodiment may be manufactured by mechanically and electrically connecting a plurality of panel regions such as the first panel region (A1) through tiling.

The first panel region (A1) may include a plurality of light-emitting devices (150) disposed for each unit pixel (PX in FIG. 2).

For example, the unit pixel (PX) may include a first sub-pixel (PX1), a second sub-pixel (PX2), and a third sub-pixel (PX3). For example, a plurality of red light-emitting devices (150R) may be disposed in the first sub-pixel (PX1), a plurality of green light-emitting devices (150G) may be disposed in the second sub-pixel (PX2), and a plurality of blue light-emitting devices (150B) may be disposed in the third sub-pixel (PX3). The unit pixel (PX) may further include a fourth sub-pixel in which the light-emitting device is not disposed, but is not limited thereto. Meanwhile, the light-emitting device (150) may be a semiconductor light-emitting device.

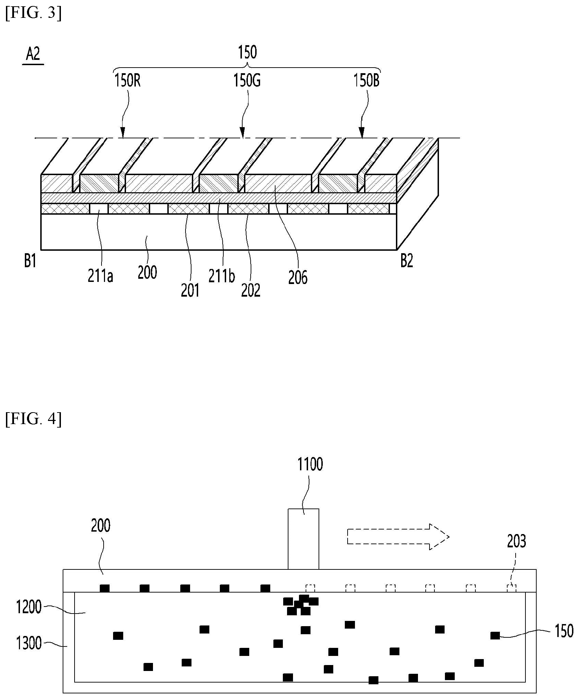

Next, FIG. 3 is a cross-sectional view taken along line B1-B2 of region A2 of FIG. 2.

Referring to FIG. 3, the display device (100) of the embodiment may include a substrate (200), assembly wirings (201, 202), a first insulating layer (211a), a second insulating layer (211b), a third insulating layer (206), and a plurality of light-emitting devices (150).

The assembly wirings may include a first assembly wiring (201) and a second assembly wiring (202) spaced apart from each other. The first assembly wiring (201) and the second assembly wiring (202) may be provided to generate a dielectrophoretic force in order to assemble the light-emitting device (150). In addition, the first assembly wiring (201) and the second assembly wiring (202) may be electrically connected to electrodes of the light-emitting device and may function as electrodes of the display panel.

The assembly wirings (201, 202) may be formed of a transparent electrode (ITO) or may include a metal material having excellent electrical conductivity. For example, the assembly wirings (201, 202) may be formed of at least one selected from titanium (Ti), chromium (Cr), nickel (Ni), aluminum (Al), platinum (Pt), gold (Au), tungsten (W), and molybdenum (Mo), or an alloy thereof.

The first insulating layer (211a) may be disposed between the first assembly wiring (201) and the second assembly wiring (202), and the second insulating layer (211b) may be disposed on the first assembly wiring (201) and the second assembly wiring (202). The first insulating layer (211a) and the second insulating layer (211b) may be an oxide film, a nitride film, or the like, but are not limited thereto.

The light-emitting device (150) may include a red light-emitting device (150R), a green light-emitting device (150G), and a blue light-emitting device (150B) in order to form each unit pixel (sub-pixel), but is not limited thereto, and red and green may be implemented by including a red phosphor and a green phosphor.

The substrate (200) may be formed of glass or polyimide. In addition, the substrate (200) may include a flexible material such as PEN (Polyethylene Naphthalate) or PET (Polyethylene Terephthalate). In addition, the substrate (200) may be a transparent material, but is not limited thereto.

The third insulating layer (206) may include an insulating and flexible material such as polyimide, PEN, or PET, and may be integrally formed with the substrate (200) to form one substrate.

The third insulating layer (206) may be a conductive adhesive layer having adhesion and conductivity, and the conductive adhesive layer may have flexibility so that a flexible function of the display device can be enabled. For example, the third insulating layer (206) may be an anisotropy conductive film (ACF) or a conductive adhesive layer such as an anisotropy conductive medium or a solution containing conductive particles. The conductive adhesive layer may be a layer that is electrically conductive in a vertical direction with respect to thickness but electrically insulating in a horizontal direction with respect to thickness.

The third insulating layer (206) may include an assembly hole (203) into which the light-emitting device (150) is inserted. Accordingly, during self-assembly, the light-emitting device (150) may be easily inserted into the assembly hole (203) of the third insulating layer (206). The assembly hole (203) may be referred to as an insertion hole, a fixing hole, or an alignment hole.

A spacing between the assembly wirings (201, 202) may be formed to be smaller than a width of the light-emitting device (150) and a width of the assembly hole (203), so that an assembly position of the light-emitting device (150) using an electric field may be more precisely fixed.

The third insulating layer (206) may be formed on the assembly wirings (201, 202) to protect the assembly wirings (201, 202) from a fluid (1200) and prevent leakage of current flowing through the assembly wirings (201, 202). The third insulating layer (206) may be formed of an inorganic insulator such as silica or alumina or an organic insulator in a single layer or multiple layers.

In addition, the third insulating layer (206) may include an insulating and flexible material such as polyimide, PEN, or PET, and may be integrally formed with the substrate (200) to form one substrate.

The third insulating layer (206) may be an adhesive insulating layer or a conductive adhesive layer having conductivity. The third insulating layer (206) may have flexibility so that the flexible function of the display device can be enabled.

The third insulating layer (206) may include a partition wall, and the assembly hole (203) may be formed by the partition wall. For example, when forming the substrate (200), a portion of the third insulating layer (206) may be removed so that each of the light-emitting devices (150) may be assembled in the assembly hole (203) of the third insulating layer (206).

The substrate (200) may include the assembly hole (203) to which the light-emitting devices (150) are coupled, and a surface on which the assembly hole (203) is formed may contact the fluid (1200). The assembly hole (203) may guide an accurate assembly position of the light-emitting device (150).

Meanwhile, the assembly hole (203) may have a shape and size corresponding to a shape of the light-emitting device (150) to be assembled at a corresponding position. Accordingly, another light-emitting device may be assembled in the assembly hole (203) or a plurality of light-emitting devices may be prevented from being assembled therein.

FIG. 4 is a view illustrating an example in which a light-emitting device according to the embodiment is assembled on a substrate by a self-assembly method, and the self-assembly method of the light-emitting device will be described with reference to the drawings.

The substrate (200) may be a panel substrate of the display device. In the following description, the substrate (200) will be described as a case where the substrate (200) is the panel substrate of the display device, but the embodiment is not limited thereto.

Referring to FIG. 4, a plurality of light-emitting devices (150) may be introduced into a chamber (1300) filled with a fluid (1200). The fluid (1200) may be water such as ultra-pure water, but is not limited thereto. The chamber may be referred to as a water tank, a container, or a vessel.

Thereafter, the substrate (200) may be disposed on the chamber (1300). According to an embodiment, the substrate (200) may be introduced into the chamber (1300).

As illustrated in FIG. 3, a pair of assembly wirings (201, 202) corresponding to each of the light-emitting devices (150) to be assembled may be disposed on the substrate (200).

Referring to FIG. 4, after the substrate (200) is disposed, an assembly device (1100) including a magnetic body may move along the substrate (200). For example, a magnet or an electromagnet may be used as the magnetic body. The assembly device (1100) may move while being in contact with the substrate (200) in order to maximize a region to which a magnetic field reaches within the fluid (1200). According to an embodiment, the assembly device (1100) may include a plurality of magnetic bodies or may include a magnetic body having a size corresponding to the substrate (200). In this case, a moving distance of the assembly device (1100) may be limited within a predetermined range.

Due to the magnetic field generated by the assembly device (1100), the light-emitting device (150) in the chamber (1300) may move toward the assembly device (1100).

While the light-emitting device (150) moves toward the assembly device (1100), the light-emitting device (150) may enter the assembly hole (203) by a dielectrophoretic force (DEP force) and may contact the substrate (200).

Specifically, the assembly wirings (201, 202) form an electric field by power supplied from the outside, and a dielectrophoretic force may be formed between the assembly wirings (201, 202) by the electric field. The light-emitting device (150) may be fixed in the assembly hole (203) on the substrate (200) by the dielectrophoretic force.

By the electric field applied by the assembly wirings (201, 202) formed on the substrate (200), the light-emitting device (150) contacting the substrate (200) may be prevented from being separated by movement of the assembly device (1100). According to the embodiment, by the self-assembly method using the above-described electromagnetic field, time required for assembling each of the light-emitting devices (150) to the substrate (200) can be significantly shortened, so that a large-area high-resolution display can be implemented more rapidly and economically.

At this time, a predetermined solder layer (not shown) may be formed between the light-emitting device (150) assembled on the assembly hole (203) of the substrate (200) and the assembly electrode to improve bonding force of the light-emitting device (150).

Next, a molding layer (not shown) may be formed in the assembly hole (203) of the substrate (200). The molding layer may be a light-transmitting resin or a resin including a reflective material or a scattering material.

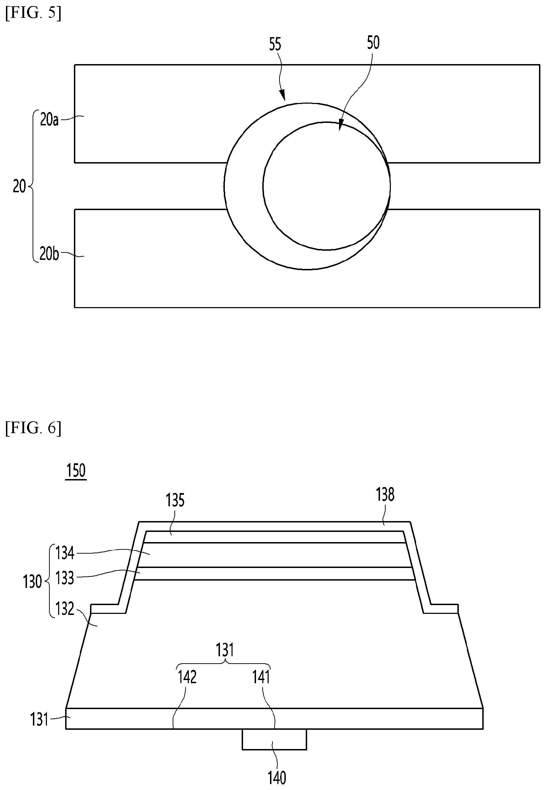

FIG. 5 is a conceptual view illustrating a state in which a semiconductor light-emitting device studied in internally developed technology is assembled on an assembly substrate. Referring to FIG. 5, an insulating layer (not shown) may be disposed on a plurality of assembly wirings (20), and a partition wall (not shown) including an assembly hole (55) may be disposed on the insulating layer. The plurality of assembly wirings (20) may include a first assembly wiring (20a) and a second assembly wiring (20b) spaced apart from each other. A DEP force may be generated between the first assembly wiring (20a) and the second assembly wiring (20b) so that the semiconductor light-emitting device (50) may be assembled in the assembly hole (55). Meanwhile, a rear surface of the semiconductor light-emitting device (50) is flat, and a center of the semiconductor light-emitting device (50) may be disposed to be biased to one side within the assembly hole (55). Accordingly, in a process of picking up the semiconductor light-emitting device to a final substrate, there is a problem in that transfer defects may occur because the center of the semiconductor light-emitting device cannot be picked up. In addition, an empty space may occur within the assembly hole (55), so that a double defect in which a subsequent chip is caught may occur.

Hereinafter, an embodiment for solving the above problem will be described.

FIG. 6 is a cross-sectional view of a semiconductor light-emitting device according to a first embodiment. Referring to FIG. 6, the semiconductor light-emitting device (150) for a display pixel may include a light-emitting structure (130), a first electrode (131), a second electrode (135), a passivation layer (138), and an aligner (140). The semiconductor light-emitting device (150) may be a vertical semiconductor device. In addition, the semiconductor light-emitting device (150) may be a lateral semiconductor light-emitting device.

The light-emitting structure (130) may include a first conductivity-type semiconductor layer (132), an active layer (133) disposed on the first conductivity-type semiconductor layer (132), and a second conductivity-type semiconductor layer (134) disposed on the active layer (133).

The first conductivity-type semiconductor layer (132) may be an n-type semiconductor layer, and the second conductivity-type semiconductor layer (134) may be a p-type semiconductor layer, but are not limited thereto. The first conductivity-type semiconductor layer (132), the active layer (133), and the second conductivity-type semiconductor layer (134) may be formed of a compound semiconductor material. For example, the compound semiconductor material may be a group III-V compound semiconductor material or a group II-VI compound semiconductor material. For example, the compound semiconductor material may be selected from the group consisting of binary compounds selected from the group consisting of GaP, GaAs, GaSb, AlP, AlAs, AlSb, InP, InAs, InSb, and mixtures thereof; ternary compounds selected from the group consisting of GaNP, GaNAs, GaNSb, GaPAs, GaPSb, AlInP, AlNP, AlNAs, AlNSb, AlPAs, AlPSb, InNP, InNAs, InNSb, InPAs, InPSb, GaAlNP, and mixtures thereof; and quaternary compounds selected from the group consisting of AlGaInP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and mixtures thereof.

For example, the first conductivity-type semiconductor layer (132) may include a first conductivity-type dopant, and the second conductivity-type semiconductor layer (134) may include a second conductivity-type dopant. For example, the first conductivity-type dopant may be an n-type dopant such as silicon (Si), and the second conductivity-type dopant may be a p-type dopant such as boron (B).

The active layer (133) is a region generating light and may generate light having a specific wavelength band according to material characteristics of the compound semiconductor. In addition, the active layer (133) may have a multiple quantum well structure or a single quantum well structure, and the wavelength band may be determined by an energy bandgap of the compound semiconductor included in the active layer (133). Accordingly, depending on the energy bandgap of the compound semiconductor included in the active layer (133), the semiconductor light-emitting device of the embodiment may generate UV light, blue light, green light, or red light.

The first electrode (131) disposed below the light-emitting structure (130) may include an ohmic contact layer. In addition, the first electrode (131) may include a magnetic material. In addition, the second electrode (135) disposed on the light-emitting structure (130) may be formed as a transparent electrode. For example, the second electrode (135) may include ITO, IZO, or ZnO.

Meanwhile, the aligner (140) may be disposed below the first electrode (131). The aligner (140) may be disposed in a central region of the semiconductor light-emitting device (150). A lower surface of the first electrode (131) may include a first region (141) in which the aligner (140) is disposed and an electrode region (142) in which the aligner (140) is not disposed. In addition, a center of the aligner (140) may be formed to overlap a center of the semiconductor light-emitting device (150). The aligner (140) may include an insulating material. For example, the aligner (140) may include SiO2 or SiNx, but is not limited thereto.

Meanwhile, the semiconductor light-emitting device (150) may be dispersed in a fluid and assembled on an assembly substrate. At this time, a rear surface of the semiconductor light-emitting device (150) may have a step due to the aligner (140). Accordingly, the semiconductor light-emitting device (150) may be disposed such that the rear surface faces upward in the fluid. In addition, the semiconductor light-emitting device (150) may be disposed such that a surface to be assembled faces the assembly substrate. In addition, the aligner (140) of the semiconductor light-emitting device (150) may be disposed to face the assembly substrate. Accordingly, during self-assembly, the semiconductor light-emitting device (150) may be prevented from being flipped or not assembled due to a DEP force not being applied. Therefore, the embodiment can improve a correct assembly rate of the semiconductor light-emitting device.

In addition, since the embodiment has a step due to the aligner, during self-assembly the semiconductor light-emitting device may be assembled at a position corresponding to the aligner instead of being assembled at a random position in the assembly hole of the substrate. Accordingly, the embodiment can assemble the semiconductor light-emitting device at an exact center of the assembly hole and can control directionality.

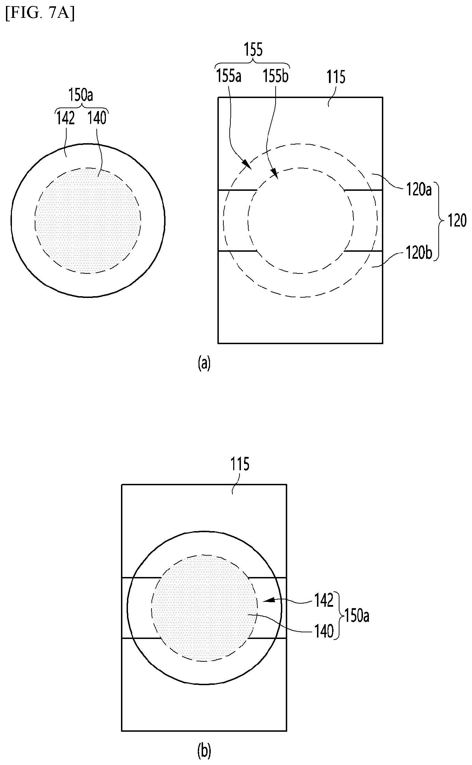

FIGS. 7A to 7D are conceptual views illustrating shapes of aligners of semiconductor light-emitting devices according to second to fifth embodiments.

Referring to FIG. 7A (a), a conceptual view illustrating a rear surface of a semiconductor light-emitting device (150a), an assembly electrode (120), and an insulating layer (115) is shown. The aligner (140) may be provided on the rear surface of the semiconductor light-emitting device (150a). In addition, a region in which the aligner (140) is not disposed on the rear surface is a part of the first electrode and may be referred to as the electrode region (142).

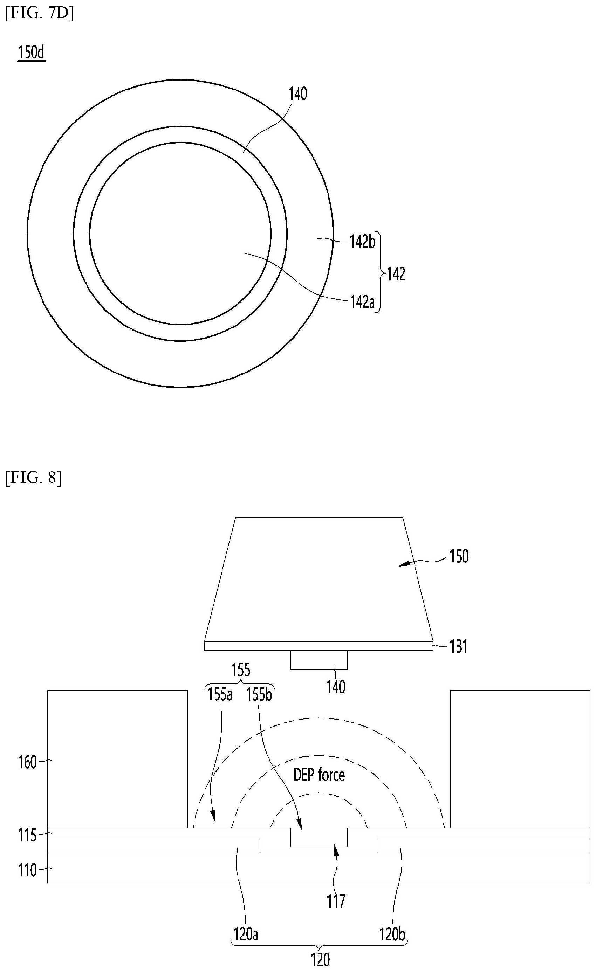

Meanwhile, on an assembly substrate, assembly wirings (120) may be disposed on the substrate (see FIG. 8). The assembly wirings (120) may include a first assembly wiring (120a) and a second assembly wiring (120b) spaced apart from each other. The insulating layer (115) may be disposed on the assembly wirings (120), and an assembly hole (155) may be disposed on the insulating layer (115).

The assembly hole (155) may include a first assembly hole (155a) and a second assembly hole (155b). The second assembly hole (155b) may be located on the same plane as the assembly wirings (120) (see FIG. 7A and FIG. 8). In addition, the first assembly hole (155a) may be located on the assembly wirings (120) and may be located on the insulating layer (115).

In addition, the assembly wirings (120) may have a shape corresponding to the second assembly hole (155b). In addition, the insulating layer (115) may correspond to the shape of the second assembly hole (155b) in the assembly wirings (120).

In addition, the second assembly hole (155b) may be located on the assembly wirings (120). At this time, the second assembly hole (155b) may be located on the same plane as the insulating layer (115). In addition, the first assembly hole (155a) may be located on the insulating layer (115).

Referring to FIG. 7A (b), the aligner (140) of the semiconductor light-emitting device (150a) may be located within the second assembly hole (155b). The aligner (140) may correspond to the size and shape of the second assembly hole (155b). Accordingly, in the second embodiment, since the aligner (140) performs an anchor function, the semiconductor light-emitting device can be physically fixed to the assembly substrate.

In addition, the electrode region (142) of the semiconductor light-emitting device (150a) may be located in the first assembly hole (155a). The DEP force generated from the assembly wirings (120) may be uniformly applied to the electrode region (142). Accordingly, in the second embodiment, the electrode region (142) is symmetrically defined by the aligner (140), and the DEP force is uniformly applied, so that the chip can be assembled at a center of the assembly hole (155).

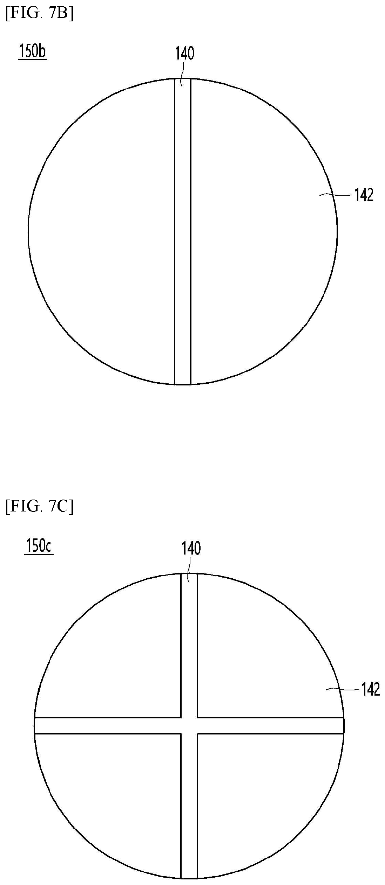

Referring to FIG. 7B, the aligner (140) may be disposed on a rear surface of the semiconductor light-emitting device (150b) of the third embodiment. The aligner (140) may be formed to have a shape crossing a center from one end of the rear surface of the semiconductor light-emitting device (150b). The aligner (140) may be positioned to overlap between a plurality of assembly wirings in the assembly substrate. In addition, the electrode region (142) in which the aligner (140) is not disposed may be symmetrical with respect to the aligner (140). Accordingly, the DEP force acts symmetrically, so that there is a technical effect in that the semiconductor light-emitting device can be guided to a center of the assembly hole.

Referring to FIG. 7C, the aligner (140) may be disposed on a rear surface of the semiconductor light-emitting device (150c) of the fourth embodiment. The aligner (140) may have a shape crossing each other at a center. The electrode region (142) may be divided into a plurality of regions by the aligner (140). In the electrode region (142), the DEP force may be applied to each of the plurality of regions. In addition, an insulating layer of the assembly hole may have a shape corresponding to the shape of the aligner (140). Accordingly, there is a technical effect in that the semiconductor light-emitting device (150c) of the fourth embodiment can be assembled at a preset position within the assembly hole.

Referring to FIG. 7D, the aligner (140) may be disposed on a rear surface of the semiconductor light-emitting device (150d) of the fifth embodiment. A center of the aligner (140) may be the same as a center of the rear surface of the semiconductor light-emitting device (150d). The aligner (140) may have a ring shape in a horizontal cross section. Accordingly, the rear surface of the semiconductor light-emitting device (150d) may be divided by the aligner (140) into a first electrode region (142a) located inside and a second electrode region (142b) located outside. Accordingly, there is a technical effect in that the DEP force acts on an inner side and an outer side of the rear surface of the semiconductor light-emitting device with respect to the aligner (140), thereby improving an assembly rate.

FIG. 8 is a conceptual view illustrating a process in which the semiconductor light-emitting device (150) is assembled on a substrate in the semiconductor light-emitting device for a display pixel and the display device including the same according to the sixth embodiment. Referring to FIG. 8, a plurality of assembly wirings (120) may be disposed on a substrate (110), and an insulating layer (115) may be disposed on the assembly wirings (120). In addition, a partition wall (160) including an assembly hole (155) may be disposed on the insulating layer (115). The assembly hole (155) may be circular or elliptical, but is not limited thereto. In addition, a lower surface of the semiconductor light-emitting device may be circular or elliptical, but is not limited thereto.

The plurality of assembly wirings (120) may form a DEP force by alternating current application of powers having opposite polarity to each other, and the semiconductor light-emitting device (150) may be assembled in the assembly hole (155) by the DEP force.

On the other hand, in the sixth embodiment, the insulating layer (115) may include a groove (117). The groove (117) may include a polygonal shape such as a circular shape, an elliptical shape, and a quadrangular shape. The plurality of assembly wirings (120) may not be exposed by the groove (117). Alternatively, the plurality of assembly wirings (120) may be exposed by the groove (117). A center of the groove (117) may correspond to a center of the assembly hole (155). The groove (117) may not be biased to one side within the assembly hole (155).

At this time, the semiconductor light-emitting device (150) may include the aligner (140). The aligner (140) may have a shape corresponding to the groove (117) of the insulating layer (115). A center of the aligner (140) may correspond to a center of the rear surface of the semiconductor light-emitting device (150).

A rear surface of the semiconductor light-emitting device (150) may include the aligner (140) and an electrode region in which the aligner (140) is not disposed. The electrode region may be symmetrically distributed by the aligner (140).

When the DEP force is formed by the plurality of assembly wirings (120), the DEP force is symmetrically applied to the symmetrically distributed electrode region, so that there is a technical effect in that an assembly force can be uniformly applied to the semiconductor light-emitting device (150).

In addition, the semiconductor light-emitting device (150) may have a step by the aligner (140). Accordingly, the semiconductor light-emitting device (150) may not be assembled when the aligner (140) is located in a region other than the groove (117). When the aligner (140) is located within the groove (117), correct assembly may be achieved.

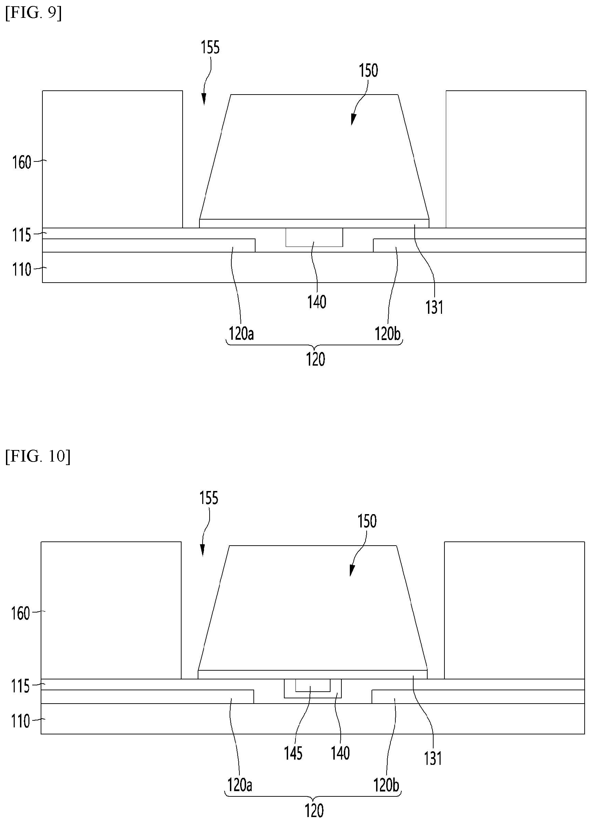

FIG. 9 is a conceptual view illustrating a state in which the semiconductor light-emitting device (150) is assembled on the assembly substrate in the sixth embodiment of FIG. 8. Referring to FIG. 9, the semiconductor light-emitting device (150) may be assembled in the assembly hole (155). The aligner (140) of the semiconductor light-emitting device (150) may be located in a groove provided in the insulating layer (115).

The aligner (140) may correspond to a shape of the groove. Accordingly, the semiconductor light-emitting device (150) may be physically fixed to the assembly substrate by the aligner (140). Accordingly, the aligner (140) may perform an anchor function. Therefore, the embodiment has a technical effect of preventing the assembled semiconductor light-emitting device (150) from being removed even if there is a collision of a subsequent chip after the semiconductor light-emitting device is assembled on the assembly substrate. In addition, the semiconductor light-emitting device can maintain an assembled state even when the DEP force of the plurality of assembly wirings (120) disappears.

In addition, although not illustrated in the drawings, when a passivation layer is formed on a lower surface of the semiconductor light-emitting device (150), the insulating layer (115) may be omitted. At this time, the aligner (140) of the semiconductor light-emitting device (150) is located between the plurality of assembly wirings (120) and may have a corresponding shape.

Therefore, in the sixth embodiment, as the semiconductor light-emitting device includes the aligner (140) on the rear surface, there is a technical effect in that the DEP force is controlled to improve an assembly force and, even after assembly, the anchor function is performed so that the semiconductor light-emitting device is physically fixed to prevent separation of the chip.

In addition, in the sixth embodiment, as the semiconductor light-emitting device is assembled at an exact center of the assembly hole, there is a technical effect in that a double defect in which two or more chips are located in one assembly hole is prevented. In addition, since a center of the semiconductor light-emitting device is located at a center of the assembly hole during a transfer process, transfer defects are prevented and thus a transfer rate can be improved.

FIG. 10 is a conceptual view of the semiconductor light-emitting device for a display pixel and the display device including the same according to the seventh embodiment. Referring to FIG. 10, the semiconductor light-emitting device (150) may include the aligner (140) on a rear surface. A second magnetic layer (145) may be disposed in the aligner (140). The second magnetic layer (145) may include a magnetic material. The second magnetic layer (145) may include a material different from that of the first electrode (131), but is not limited thereto.

The second magnetic layer (145) may be located below the first electrode (131). During self-assembly in a fluid, when an assembly magnet pulls the semiconductor light-emitting device to the assembly substrate, the second magnetic layer (145) is located at a center of the rear surface of the semiconductor light-emitting device (150), so that the semiconductor light-emitting device can be guided to be positioned at a center of the assembly hole (155).

In addition, when the DEP force is generated in the assembly wirings (120) to assemble the semiconductor light-emitting device, the DEP force may be applied not only to the first electrode (131) but also to the second magnetic layer (145) located in a central portion. Accordingly, the DEP force is concentrated on a central portion of the rear surface of the semiconductor light-emitting device (150), so that the semiconductor light-emitting device can be guided to be positioned at a center of the assembly hole (155). Therefore, in the seventh embodiment, the semiconductor light-emitting device (150) is guided to be positioned at a center of the assembly hole (155), and thus there is a technical effect in that an assembly rate can be further improved.

The semiconductor light-emitting device for a display pixel according to the embodiment and the display device including the same have a technical effect of preventing a double defect in which two or more chips are assembled in one assembly hole during self-assembly.

For example, in the embodiment, as the semiconductor light-emitting device is positioned at a center of the assembly hole by the aligner, a remaining space is reduced, so that a subsequent chip can be prevented from being additionally assembled.

In addition, the embodiment has a technical effect of improving a transfer rate during self-assembly.

For example, in the embodiment, the semiconductor light-emitting device is positioned at a center of the assembly hole, so that the semiconductor light-emitting device is transferred to a correct position during a transfer process and thus the transfer rate can be improved.

In addition, the embodiment has a technical effect of preventing separation of an assembled chip.

For example, in the embodiment, the semiconductor light-emitting device is fixed to the substrate by the aligner, so that separation of the chip can be prevented.

In addition, the embodiment has a technical effect of improving an assembly force during self-assembly.

For example, in the embodiment, regions receiving the DEP force are symmetrically disposed with respect to the aligner on the rear surface, so that the assembly force can be improved.

In addition, the embodiment has a technical effect of physically fixing the chip to the substrate without a separate member.

For example, in the embodiment, the aligner on the rear surface performs an anchor function, so that the chip can be physically fixed to the substrate without a separate member.

Although the embodiments of the present invention have been described above with reference to the embodiments, those skilled in the art will readily understand that the present invention may be variously modified and changed without departing from the spirit and scope of the present invention set forth in the following claims.

### Industrial Applicability

The embodiment can be applied to a display device, but is not limited thereto. For example, the embodiment can be applied to a micro-LED display using an LED, which is an inorganic light-emitting device, as a light-emitting pixel, but is not limited thereto.

## Claims

1. A semiconductor light-emitting device for a display pixel, comprising:
a light-emitting structure comprising a first conductivity-type semiconductor layer, an active layer, and a second conductivity-type semiconductor layer; and
a first electrode disposed below the light-emitting structure and comprising an electrode region and a first region; and
an aligner of an insulating material disposed on the first region of the first electrode.

2. The semiconductor light-emitting device for a display pixel according to claim 1, wherein a center of the aligner corresponds to a center of the first electrode.

3. The semiconductor light-emitting device for a display pixel according to claim 1, wherein the electrode region does not overlap the aligner in a vertical direction.

4. The semiconductor light-emitting device for a display pixel according to claim 1, wherein the aligner crosses a center of a lower surface of the first electrode.

5. The semiconductor light-emitting device for a display pixel according to claim 1, wherein the aligner has a ring shape in a horizontal cross section.

6. The semiconductor light-emitting device for a display pixel according to claim 1, further comprising a magnetic layer disposed in the aligner.

7. The semiconductor light-emitting device for a display pixel according to claim 1, wherein the first region surrounds the electrode region.

8. A display device comprising a semiconductor light-emitting device, the display device comprising:
a substrate;
a plurality of assembly wirings disposed on the substrate;
an insulating layer disposed on the assembly wirings;
a partition wall disposed on the insulating layer and comprising an assembly hole; and
the semiconductor light-emitting device disposed in the assembly hole,
wherein the semiconductor light-emitting device comprises a light-emitting structure, a first electrode disposed below the light-emitting structure, and an aligner disposed below the first electrode,
wherein the aligner comprises an insulating material, and
wherein the insulating layer has a first groove corresponding to a shape of the aligner.

9. The display device comprising a semiconductor light-emitting device according to claim 8, wherein the aligner is located between the plurality of assembly wirings.

10. The display device comprising a semiconductor light-emitting device according to claim 8, wherein the plurality of assembly wirings have a second groove corresponding to a shape of the aligner.

11. The display device comprising a semiconductor light-emitting device according to claim 8, wherein the semiconductor light-emitting device comprises the semiconductor light-emitting device for a display pixel according to any one of claims 1 to 7.
